# EUROPEAN PATENT APPLICATION

(11) **EP 2 881 213 A1**
(43) Date of publication of application: **10.06.2015**
(21) Application number: 14174570.3
(22) Date of filing: 26.06.2014
(51) Int. Cl.: B23K 26/00, B23K 26/36, H01L 27/12, H01L 27/32

(54) **Laser crystallization apparatus and organic light-emitting diode (oled) display manufactured using the same**

(30) Priority: 05.12.2013 KR 20130150654
(71) Applicant: Samsung Display Co., Ltd., Gyeonggi-Do (KR)
(72) Inventor: Cho, Joo Woan, Seongnam-si, Gyeonggi-do 1008-301 (KR); Cheong, Byoung Ho, Yongin-si, Gyeonggi-do 905-1101 (KR); Choo, Byoung Kwon, Hwaseong-si, Gyeonggi-do B-5101 (KR)
(74) Representative: Dr. Weitzel & Partner

(57) **Abstract**

A laser crystallization apparatus and an organic light-emitting diode (OLED) display manufactured using the same are disclosed. In one aspect, the apparatus includes a stage configured to receive a target substrate having an amorphous silicon layer formed thereon and a first laser unit configured to crystalize the amorphous silicon layer so as to form a polycrystalline silicon layer. The polycrystalline silicon layer includes a plurality of protrusions. The apparatus also includes a second laser unit configured to remove at least part of the protrusions.

## Description

### CROSS-REFERENCE TO RELATED APPLICATIONS

This application claims priority to and the benefit of Korean Patent Application No. 10-2013-0150654 filed in the Korean Intellectual Property Office on December 5, 2013.

### BACKGROUND

### Field

The described technology generally relates to a laser crystallization apparatus and an organic light-emitting diode (OLED) display manufactured using the same.

### Description of the Related Technology

Generally, amorphous silicon has a drawback in that it has a low electron mobility, i.e. a low charge carrier mobility. Polycrystalline silicon can be used in a driving circuit including a thin film transistor (TFT) on a substrate, which is not possible with amorphous silicon. Therefore, TFTs that are manufactured with polycrystalline silicon do not need a plurality of terminal connections and a driver integrated circuit (IC). Thus, productivity and reliability can be improved and the thickness of a display panel may be reduced when using polycrystalline silicon TFTs.

Methods of manufacturing such polycrystalline silicon TFTs at a low temperature include solid phase crystallization (SPC), metal induced crystallization (MIC), metal induced lateral crystallization (MILC), and excimer laser annealing (ELA). Particularly, when manufacturing an organic light-emitting diode (OLED) display or a liquid crystal display (LCD), the excimer laser annealing method is typically used and includes using a high energy laser beam to perform crystallization.

### SUMMARY OF CERTAIN INVENTIVE ASPECTS

One inventive aspect is a laser crystallization apparatus which crystallizes an amorphous silicon layer into a polycrystalline silicon layer and an OLED display manufactured using the same.

Another aspect is a laser crystallization apparatus which removes protrusions which are generated in a polycrystalline silicon layer during laser crystallization and an OLED display manufactured using the same.

Another aspect is a laser crystallization apparatus including a stage on which a target substrate having an amorphous silicon layer formed thereon is mounted, a first laser unit which performs a laser crystallization process which transforms the amorphous silicon layer into a polycrystalline silicon layer, and a second laser unit which performs an ablation process which removes protrusions generated on the polycrystalline silicon layer.

Further, the first laser unit may include a first laser generator which generates a first laser beam and a first optical system which optically converts the first laser beam and the second laser unit may include a second laser generator which generates a second laser beam and a second optical system which optically converts the second laser beam.

The second optical system may change the second laser beam into a line beam.

The second optical system may change the second laser beam into a conical beam.

A depth of focus of the second laser beam may match a surface of the polycrystalline silicon layer.

The depth of focus of the second laser beam may be selected to be lower than a height of the protrusion.

A process time interval of a laser crystallization process by the first laser unit and a protrusion removal process by the second laser unit may be several nanoseconds (ns) to several seconds (s).

Optical axes of the first laser beam and the second laser beam may be perpendicular to a surface of the polycrystalline silicon layer.

Optical axes of the first laser beam and the second laser beam may be inclined with respect to a surface of the polycrystalline silicon layer.

Another aspect is an organic light-emitting diode (OLED) display including a substrate, a switching semiconductor layer and a driving semiconductor layer which are formed on the substrate, a gate insulating layer which covers the switching semiconductor layer and the driving semiconductor layer, a switching gate electrode and a driving gate electrode which are formed the gate insulating layer and overlap the switching semiconductor layer and the driving semiconductor layer, an interlayer insulating layer which covers the switching gate electrode and the driving gate electrode, a switching source electrode and a switching drain electrode which are formed on the interlayer insulating layer and are connected to the switching semiconductor layer, a driving source electrode and a driving drain electrode which are formed on the interlayer insulating layer and are connected to the driving semiconductor layer, and an OLED which is connected to the driving drain electrode, in which the switching semiconductor layer and the driving semiconductor layer may be formed of a polycrystalline silicon layer and the height of protrusions formed on the polycrystalline silicon layer may have a value between a value obtained by adding -20% of a thickness of the polycrystalline silicon layer to the thickness of the polycrystalline silicon layer and a value obtained by adding 20% of the thickness of the polycrystalline silicon layer to the thickness of the polycrystalline silicon layer.

The height of the protrusions which are formed on the polycrystalline silicon layer may have a value between a value obtained by adding -10 nm which is -20% of the thickness of the polycrystalline silicon layer to the thickness of the polycrystalline silicon layer and a value obtained by adding 10 nm which is 20% of the thickness of the polycrystalline silicon layer to the thickness of the polycrystalline silicon layer.

The protrusions may be formed at grain boundaries of the polycrystalline silicon layer.

The OLED may include a first electrode which is connected to the driving drain electrode, an organic emission layer which is formed on the first electrode, and a second electrode which is formed on the organic emission layer.

Another aspect is a laser crystallization apparatus for an OLED display, the apparatus including a stage configured to receive a target substrate having an amorphous silicon layer formed thereon, a first laser unit configured to crystalize the amorphous silicon layer so as to form a polycrystalline silicon layer, wherein the polycrystalline silicon layer includes a plurality of protrusions, and a second laser unit configured to remove at least part of the protrusions.

The first laser unit includes a first laser generator configured to generate a first laser beam and a first focuser configured to focus the first laser beam and the second laser unit includes a second laser generator configured to generate a second laser beam and a second focuser configured to focus the second laser beam. The second focuser is further configured to focus the second laser beam into a line beam. The second focuser is further configured to focus the second laser beam into a conical beam. The second focuser is further configured to focus the second laser beam so as to have a depth of focus near an upper surface of the polycrystalline silicon layer. The second focuser is further configured to focus the second laser beam so as to have a focal point which is closer to the upper surface of the polycrystalline silicon layer than the heights of the protrusions.

The second laser unit is further configured to remove at least a part of the protrusions between about several nanoseconds (ns) to about several seconds (s) after the first laser unit crystalizes the amorphous silicon layer. Each of the first and second laser beams has an optical axis which is substantially perpendicular to an upper surface of the polycrystalline silicon layer. Each of the first and second laser beams has and optical axis which is inclined with respect to an upper surface of the polycrystalline silicon layer.

Another aspect is an OLED display including a substrate and a plurality of pixels formed over the substrate, each pixel including an OLED and a plurality of thin film transistors (TFTs) electrically connected to the OLED, wherein each of the TFTs includes a semiconductor layer formed at least in part of polycrystalline silicon and including a plurality of protrusions and wherein the height of each of the protrusions is between about 80% to about 120% of the thickness of the semiconductor layer.

The thickness of the semiconductor layer is about 50 nm. The protrusions are formed at grain boundaries in the polycrystalline silicon layer. Each of the OLEDs includes a first electrode electrically connected to a drain electrode of one of the TFTs, an organic emission layer formed over the first electrode, and a second electrode formed over the organic emission layer.

Another aspect is a laser crystallization apparatus for an OLED display, the apparatus including a first laser unit configured to crystalize an amorphous silicon layer formed on a substrate so as to form a polycrystalline silicon layer including a plurality of protrusions and a second laser unit configured to remove at least a part of the protrusions.

The second laser unit includes a laser generator configured to generate a laser beam and a focuser configured to focus the laser beam to have a focal point near an upper surface of the polycrystalline silicon layer. Each of the protrusions has an initial height measured before the second laser unit removes at least a part of the protrusions and the focuser is further configured to focus the laser beam such that the focal point is closer to the upper surface than the initial height of the protrusions. The focuser is configured to set the focal point of the laser beam such that a final height of the protrusions measured after the second laser unit removes at least a part of the protrusions is between about 80% to about 120% of the thickness of the polycrystalline silicon layer.

The focuser is further configured to focus the laser beam to have an optical axis which is substantially perpendicular to the upper surface of the polycrystalline silicon layer. The focuser is further configured to focus the laser beam to have an optical axis which is inclined with respect to the upper surface of the polycrystalline silicon layer. The second laser unit is further configured to remove at least a part of the protrusions between about several nanoseconds (ns) to about several seconds (s) after the first laser unit crystalizes the amorphous silicon layer.

According to at least one embodiment, the second laser unit which removes the protrusions generated in the polycrystalline silicon layer is provided so that uniformity of the polycrystalline silicon layer is improved and thus electric conductivity is also improved.

Further, the first laser unit which performs the laser crystallization process and the second laser unit which performs the protrusion removal process are formed to be inline so that the number of manufacturing processes is reduced to save manufacturing cost and the complexity of laser crystallization apparatus is minimized.

Furthermore, in the OLED display which is manufactured using the laser crystallization apparatus, the protrusions are ablated to minimize the heights of the protrusions so that the characteristics of the semiconductor layer are improved.

### BRIEF DESCRIPTION OF THE DRAWINGS

FIG. 1 is a schematic diagram of a laser crystallization apparatus according to an exemplary embodiment.
FIG. 2 is a diagram illustrating the removal of protrusions using a laser crystallization apparatus according to an exemplary embodiment.
FIG. 3 is a diagram specifically illustrating a method of removing protrusions using a second laser unit of a laser crystallization apparatus according to an exemplary embodiment.
FIG. 4 is an enlarged top plan view of a region B of FIG. 2.
FIG. 5 is a schematic diagram of a laser crystallization apparatus according to another exemplary embodiment.
FIG. 6 is an equivalent circuit diagram of one pixel of an OLED display according to another exemplary embodiment.
FIG. 7 is a layout view of one pixel of an OLED display according to another exemplary embodiment.
FIG. 8 is a cross-sectional view taken along the line XIII-XIII of FIG. 7.

### DETAILED DESCRIPTION OF CERTAIN INVENTIVE EMBODIMENTS

When an excimer laser annealing (ELA) method is used to crystalize a target thin film, protrusions are formed at grain boundaries in the thin film. The protrusions affect the characteristics of the polycrystalline silicon layer, and thus the protrusions should be removed. The standard method of protrusion removal includes a semiconductor process such as a chemical mechanical polishing (CMP) process. However, this process is typically only effective on small wafers used in manufacturing semiconductors and is difficult to apply to large sized products, such as display devices, due to the size of the required equipment and the methods used in the process. That is, when protrusions are removed using a CMP device, in addition to removing the protrusions, the polycrystalline silicon can also be damaged or some protrusions may not be removed. Further, a large table for mounting the large glass substrate, a substrate carrier, and a slurry are required in order to perform the CMP process and an additional cleaning process must also be performed beforehand and afterward.

The described technology will be described more fully hereinafter with reference to the accompanying drawings, in which exemplary embodiments are shown. As those skilled in the art would realize, the described embodiments may be modified in various different ways, all without departing from the scope of the described technology.

Portions of the described technology which are irrelevant to the description will be omitted to clearly describe the described technology and the same elements will be designated by the same reference numerals throughout the specification.

In addition, the size and thickness of each component or element shown in the drawings may be exaggerated for understanding and ease of description, but the described technology is not limited thereto.

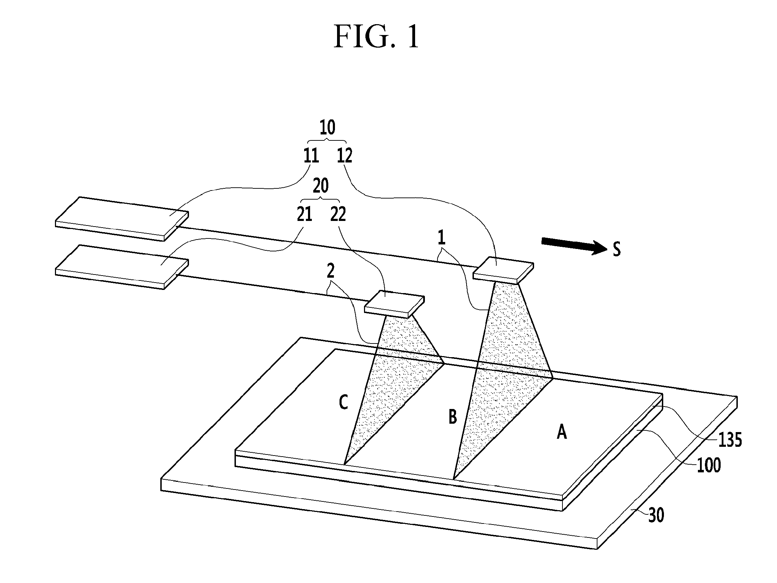

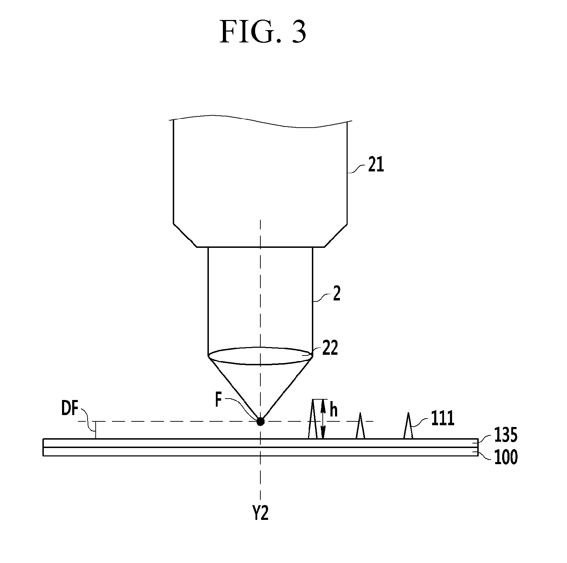

A laser crystallization apparatus according to an exemplary embodiment will be described in detail with reference to FIGS. 1 to 4.

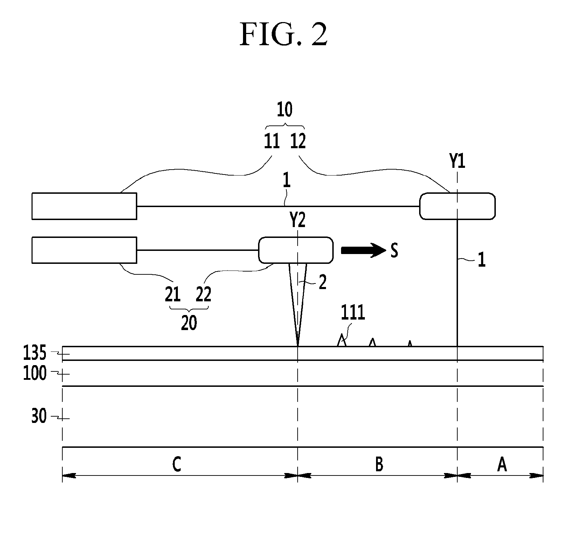

As illustrated in FIGS. 1 and 2, a laser crystallization apparatus includes a stage 30 on which a target substrate 100 having a target thin film 135 formed thereon is mounted, a first laser unit 10 which crystalizes an amorphous silicon layer A which is the target thin film 135 into a polycrystalline silicon layer B and a second laser unit 20 which removes protrusions 111 formed in the polycrystalline silicon layer B.

Both the first laser unit 10 which performs a laser crystallization process and the second laser unit 20 which performs a protrusion removal process move in a scan direction S to crystalize the amorphous silicon layer A into the polycrystalline silicon layer B and remove the protrusions 111 from the polycrystalline silicon layer B.

The first laser unit 10 which performs a laser crystallization process includes a first laser generator 11 which generates a first laser beam 1 and a first optical system or first focuser 12 which optically converts the laser beam 1.

The first laser beam 1 which is generated by the first laser generator 11 is an excimer laser beam which induces a phase change of the target thin film 135 and crystallizes the target thin film 135 formed on the target substrate 100. The target thin film 135 may be an amorphous silicon layer formed by a low pressure chemical vapor deposition method, an atmosphere chemical vapor deposition method, a plasma enhanced chemical vapor deposition method (PECVD method), a sputtering method, or a vacuum evaporation method.

The first optical system 20 focuses the first laser beam 1 into a line beam to simultaneously crystallize section of the an amorphous silicon layer A of the target thin film 135 corresponding to the length of the line beam. The laser crystallization process is quickly performed. In some embodiments, the optical axis Y1 of the first laser beam 1 is substantially perpendicular to the target thin film 135. That is, the optical axis Y1 of the first laser beam 1 is substantially perpendicular to a surface of the polycrystalline silicon layer B.

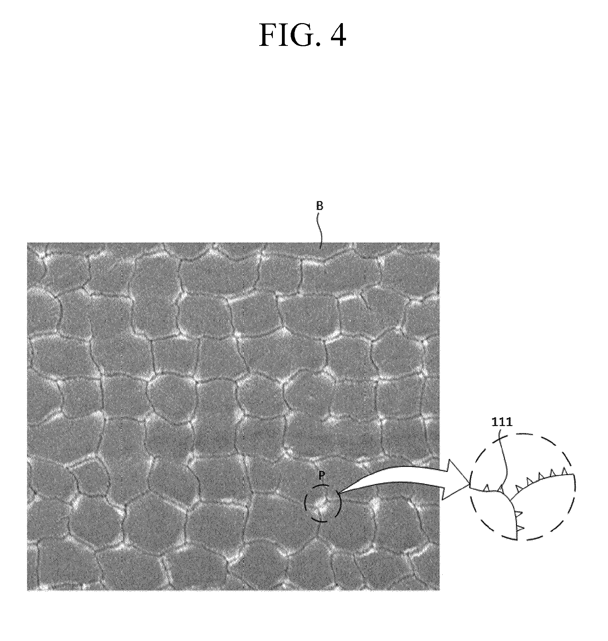

As illustrated in FIGS. 1 to 3, the target thin film 135 is formed of the amorphous silicon layer A and a region B in which the laser crystallization process is performed on the amorphous silicon layer A using the first laser unit 10 becomes the polycrystalline silicon layer B. In the polycrystalline silicon layer B, as illustrated in FIG. 4, protrusions 111 are generated at a grain boundary P. That is, the amorphous silicon layer A which is melted by the first laser beam 1 is recrystallized around grains so that the protrusions 111 are generated at the boundaries between the grains.

The second laser unit 20 which performs a protrusion removal process includes a second laser generator 21 which generates a second laser beam 2 and a second optical system or second focuser 22 which optically converts the second laser beam 2.

The second laser beam 2 which is generated by the second laser generator 21 is a laser beam having a short pulse width which is driven at a picosecond pulse width or femtosecond pulse width. The second layer beam 2 having a short pulse width substantially instantaneously applies high energy to the protrusions 111 so that multi photon absorption in the atoms which form the protrusions 111 are separated from each other, removing the protrusions 111. Further, due to the pico- to femtosecond processing time, no deformations caused by heat are generated on the polycrystalline silicon layer B so that characteristics of the polycrystalline silicon layer B are not changed.

As described above, the second laser beam 2 removes the protrusions 111 through ablation.

The second optical system 22 focuses the second laser beam 2 to be a focused line beam and a cross-section of the line beam has a substantially triangular shape which is substantially symmetrical with respect to an optical axis Y2. The optical axis Y2 of the second laser beam 2 is substantially perpendicular to the target thin film 135. That is, the optical axis Y2 of the second laser beam 2 is substantially perpendicular to a surface of the polycrystalline silicon layer B.

Therefore, the second laser beam 2 substantially simultaneously removes the protrusions 111 which are formed in a section of the target thin film 135 corresponding to the length of the line beam.

The second optical system 22 is used to adjust a depth of focus DF of the second laser beam 2. That is, the depth of focus DF is a region of the second laser beam 2 having sufficient energy for ablation to be performed. Therefore, the depth of focus DF of the second laser beam 2 is set to match to the surface of the polycrystalline silicon layer B so that the focus or focal point F of the second laser beam 2 is lower than a height H of the protrusions 111 and thus only the protrusions 111 are removed without causing damage to the polycrystalline silicon layer B.

The process time interval between the laser crystallization process of the first laser unit 10 and the protrusion removal process of the second laser unit 20 may be several nanoseconds (ns) to several seconds (s). If the process time interval is shorter than several nanoseconds, the protrusions generated by the laser crystallization process may not be completely formed prior to ablation and if the process time interval is longer than several seconds, total time for the laser crystallization process is lengthened.

Accordingly, as illustrated in FIGS. 1 and 2, the polycrystalline silicon layer B is processed to form a polycrystalline silicon layer C in which the protrusions 111 are removed by the second laser unit 20.

As described above, the second laser unit removes the protrusions generated in the polycrystalline silicon layer and is provided so that the uniformity of the polycrystalline silicon layer is improved and thus electric conductivity is also improved.

Further, the first laser unit which performs the laser crystallization process and the second laser unit which performs the protrusion removal process are formed to be inline so that the number of manufacturing processes can be reduced, reducing the manufacturing costs and simplifying the laser crystallization apparatus.

If a CMP process is performed to remove the protrusions, the size of the CMP removal device must be proportionally increased in order to handle large size panels. In contrast, according to at least one embodiment the second laser unit performs the protrusion removal process, reducing the size of the protrusion removal device.

Additionally, a separate cleansing process is required in the CMP process. However, according to at least one embodiment, the second laser unit is used to ablate the protrusions so that no separate cleansing process is required, which may reduce the number of required processes and the cost.

Further, in contrast to the CMP process, protrusions formed on a large substrate are removed so that the electric characteristics of the polycrystalline silicon layer are improved and thus productivity is increased.

According to the above description, the second optical system focuses the second laser beam as a line beam, however, according to other embodiments, the second optical system focus the second laser beam to be a conical beam so that its focus is formed in a predetermined region. In these embodiments, a separate sensor is used to find and directly remove the protrusions or entire region is scanned to find and remove the protrusions.

According to the above embodiments, the optical axes of the first and second laser beams are described as being substantially perpendicular to the target thin film, however, in other embodiments the optical axes of the first and second laser beams are inclined with respect to the target thin film.

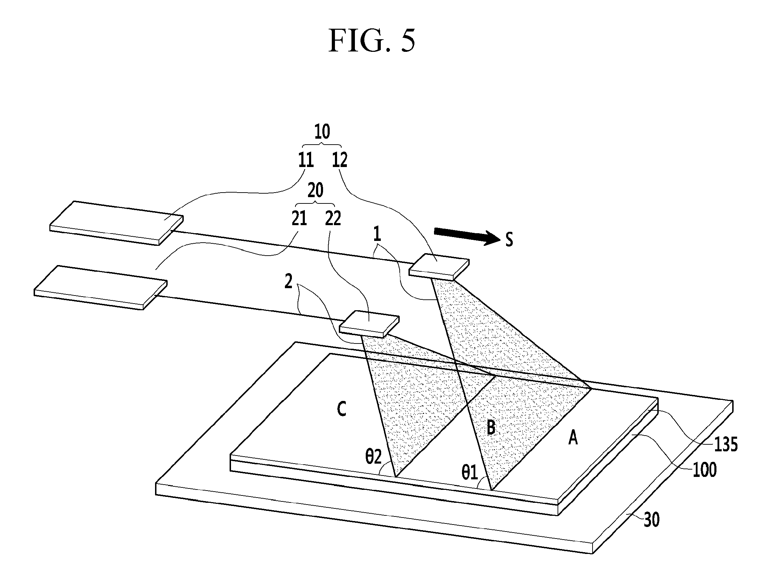

Hereinafter, a laser crystallization apparatus according to another exemplary embodiment will be described in detail with reference to FIG. 5.

FIG. 5 is a schematic diagram of a laser crystallization apparatus according to another exemplary embodiment.

The FIG. 5 embodiment is substantially similar to the embodiment illustrated in FIGS. 1 to 4 excepting that the optical axes of the first laser beam and the second laser beam are inclined with respect to the target thin film and thus redundant descriptions will be omitted.

As illustrated in FIG. 5, a first optical system 20 of a laser crystallization apparatus focuses a first laser beam 1 as a line beam to substantially simultaneously crystallize an amorphous silicon layer A region of a target thin film 135 corresponding to the length of the line beam. In this embodiment, the optical axis Y1 of the first laser beam 1 is inclined with respect to the target thin film 135 at a first inclination angle θ1. That is, the optical axis Y1 of the first laser beam 1 is inclined with respect to a surface of a polycrystalline silicon layer B at the first inclination angle θ1. In this embodiment, reflections of the first laser beam 1 from the target thin film 135 onto the first laser unit 10 are minimized so that damage to the first laser unit 10 due to the reflected first laser beam 1 is minimized.

A second optical system 22 focuses the second laser beam 2 as a focused line beam and the second laser beam substantially simultaneously remove the protrusions 111 formed in a region corresponding to the length of the line beam. In this embodiment, the optical axis Y2 of the second laser beam 2 is inclined with respect to the target thin film 135 at a second inclination angle θ2. That is, the optical axis Y2 of the second laser beam 2 is inclined with respect to the surface of the polycrystalline silicon layer B at the second inclination angle θ2. In this embodiment, reflections of the second laser beam 2 from the target thin film 135 onto the second laser unit 20 are minimized so that damage to the second laser unit 20 due to the reflected second laser beam 2 is minimized.

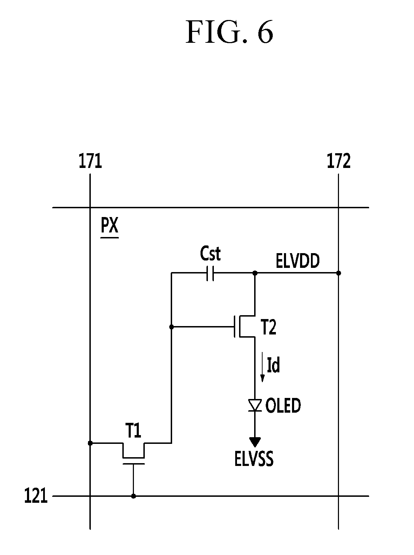

An organic light-emitting diode (OLED) display manufactured using the laser crystallization apparatus will be described below in detail with reference to FIGS. 6 to 8.

FIG. 6 is an equivalent circuit diagram of one pixel of an OLED display according to another exemplary embodiment.

As illustrated in FIG. 6, the OLED display includes a plurality of signal lines 121, 171, and 172 and a plurality of pixels PX connected to the signal lines and arranged approximately in a matrix. The signal lines includes a plurality of scan lines 121 which apply scan signals (or gate signals), a plurality of data lines 171 which apply data signals, and a plurality of driving voltage lines 172 apply a driving voltage ELVDD. The scan lines extend approximately in a row direction and are substantially parallel to each other and the data lines 171 and the driving voltage lines 172 extend approximately in a column direction and are substantially parallel to each other. Each of the pixels PX includes a switching transistor T 1, a driving transistor T2, a storage capacitor Cst, and an OLED.

The switching transistor T1 includes a control terminal, an input terminal, and an output terminal and the control terminal is connected to the scan line 121, the input terminal is connected to the data line 171, and the output terminal is connected to the driving transistor T2. The switching transistor T1 transmits the data signal which is applied to the data line 171 to the driving transistor T2 in response to the scan signal which is applied to the scan line 121.

The driving transistor T2 also includes a control terminal, an input terminal, and an output terminal. The control terminal is connected to the switching transistor T1, the input terminal is connected to the driving voltage line 172, and the output terminal is connected to the OLED. An output current Id flows through the driving transistor T2 and the intensity of the output current Id varies depending on the voltage applied between the control terminal and the output terminal of the driving transistor T2.

The storage capacitor Cst is connected between the control terminal and the input terminal of the driving transistor T2. The storage capacitor Cst stores the data signal which is applied to the control terminal of the driving transistor T2 and maintains the data signal after the switching transistor T1 is turned off.

The OLED includes an anode which is connected to the output terminal of the driving transistor T2 and a cathode which is connected to the common voltage ELVSS. The OLED emits light while varying the intensity of the light depending on the output current Id of the driving transistor T2 to display an image.

The switching transistor T 1 and the driving transistor T2 may be n channel electric field effect transistors (FETs) or p channel electric field effect transistors. The connection relationship between the transistors T1 and T2, the storage capacitor Cst, and the OLED may be variously changed.

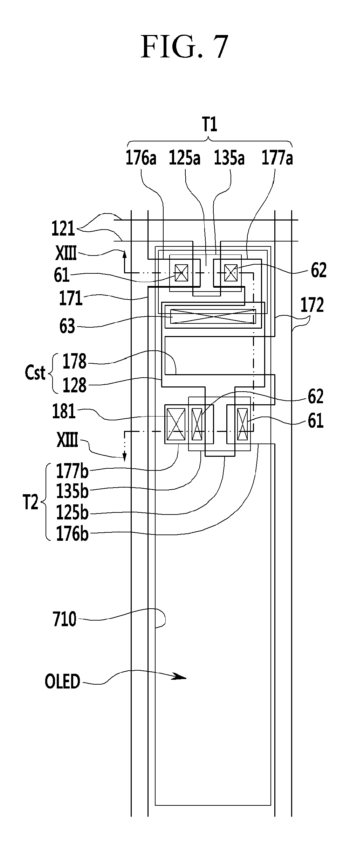

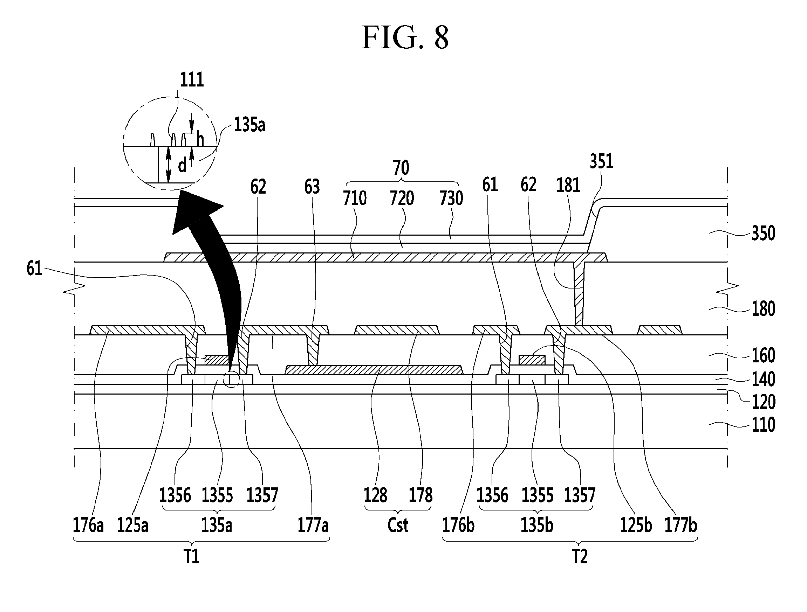

Next, a detailed structure of the pixel of the OLED display illustrated in FIG. 6 will be described in detail with reference to FIGS. 7 and 8 together with FIG. 6.

FIG. 7 is a layout view of one pixel of an OLED display according to another exemplary embodiment and FIG. 8 is a cross-sectional view taken along the line XIII-XIII of FIG. 7.

As illustrated in FIGS. 7 and 8, a substrate 100 of the OLED display may be a flexible insulating substrate formed of glass, quartz, ceramic, or plastic. A buffer layer 120 is formed on the substrate 110. The buffer layer 120 is formed to be a single layer of silicon nitride (SiNx) or a dual layer structure in which silicon nitride (SiNx) and silicon oxide (SiO₂) are laminated. The buffer layer 120 serves to block unnecessary contaminates such as impurities or moisture from penetrating from the environment and also planarizes the surface of the substrate 110.

A switching semiconductor layer 135a and a driving semiconductor layer 135b are formed on the buffer layer 120 so as to be spaced apart from each other.

The semiconductor layers 135a and 135b include a channel region in which no impurities are doped and a source region and a drain region in which impurities are doped on both sides of the channel region. Here, the type of impurity used may vary depending on the type of transistor and may include an n-type impurity or a p-type impurity.

The switching and driving semiconductor layers 135a and 135b the driving are formed of polycrystalline silicon layers. During a laser crystallization process, protrusions 111 are generated at grain boundaries of the switching or driving semiconductor layers 135a or 135b which are polycrystalline silicon layers. The heights h of the protrusions 111 formed on the polycrystalline silicon layers can have a value between a value d1 obtained by adding about -20% of a thickness d of the polycrystalline silicon layer to the thickness d of the polycrystalline silicon layer and a value d2 obtained by adding about 20% of the thickness d of the polycrystalline silicon layer to the thickness d of the polycrystalline silicon layer. For example, d1 can be about 80% of the value of d and d2 can be about 120% of the value of d such that d2 ≥ h ≥ d1. It can be difficult to perform ablation such that the heights h of the protrusions 111 are less than d1. Further, if the heights h of the protrusions 111 are larger than d2, it can be difficult to improve the electric characteristics of the polycrystalline silicon layer. However, depending on the embodiment, d1 can be less than about 80% of the values of d and d2 can be greater than about 120% of the value of d.

Specifically, if the thickness of the polycrystalline silicon layer is approximately 50 nm, the height h of the protrusions 111 formed on the polycrystalline silicon layer can be a value between a first value obtained by adding -10 nm which is -20% of the thickness d of the polycrystalline silicon layer to the thickness d of the polycrystalline silicon layer and a second value obtained by adding 10 nm which is 20% of the thickness d of the polycrystalline silicon layer to the thickness d of the polycrystalline silicon layer.

As described above, in the OLED display manufactured using the laser crystallization apparatus, the protrusions 111 are ablated to minimize the heights of the protrusions 111 so that the characteristics of the semiconductor layer can be improved.

Each of the switching and driving semiconductor layers 135a and 135b is divided into a channel region 1355 and a source region 1356 and a drain region 1357 which are formed at the sides of the channel region 1355. The channel regions 1355 of the switching and driving semiconductor layers 135a and 135b include polycrystalline silicon in which no impurities are doped, that is, an intrinsic semiconductor. The source and drain regions 1356 and 1357 of the switching and driving semiconductor layers 135a and 135b include polycrystalline silicon in which conductive impurities are doped, that is, an impurity doped semiconductor.

A gate insulating layer 140 is formed on the switching and driving semiconductor layers 135a and 135b. The gate insulating layer 140 may be a single layer or a multiple layer including at least one or more of silicon nitride and silicon oxide.

A scan line 121, a driving gate electrode 125b, and a first storage capacitor plate 128 are formed on the gate insulating layer 140. The scan line 121 extends in a horizontal direction to transmit a scan signal and includes a switching gate electrode 125a which protrudes from the scan line 121 to the switching semiconductor layer 135a. The driving gate electrode 125b protrudes from the first storage capacitor plate 128 to the driving semiconductor layer 135b. The switching and driving gate electrodes 125a and 125b respectively overlap the channel region 1355.

An interlayer insulating layer 160 is formed on the scan line 121, the driving gate electrode 125b, and the first storage capacitor plate 128. Similarly to the gate insulating layer 140, the interlayer insulating layer 160 may be formed of silicon nitride or silicon oxide.

A source contact hole 61 and a drain contact hole 62 which respectively expose the source region 1356 and the drain region 1357 are formed in the interlayer insulating layer 160 and the gate insulating layer 140. A storage contact hole 63 which exposes a part of the first storage capacitor plate 128 is also formed in the interlayer insulating layer 160.

A data line 171 which has a switching source electrode 176a and a driving voltage line 172 which includes a driving source electrode 176b and a second storage capacitor plate 178, and a switching drain electrode 177a and a driving drain electrode 177b, which are connected to the first storage capacitor plate 128, are formed on the interlayer insulating layer 160.

The data line 171 transmits a data signal and extends in a direction intersecting the gate line 121. The driving voltage line 172 transmits a driving voltage and is separated from the data line 171 and extends in substantially the same direction.

The switching source electrode 176a protrudes from the data line 171 to the switching semiconductor layer 135a and the driving source electrode 176b protrudes from the driving voltage line 172 to the driving semiconductor layer 135b. The switching source electrode 176a and the driving source electrode 176b are respectively connected to the source regions 1356 through the source contact holes 61. The switching drain electrode 177a faces the switching source electrode 176a, the driving drain electrode 177b faces the driving source electrode 176b, and the switching drain electrode 177a and the driving drain electrode 177b are respectively connected to the drain regions 1357 through the drain contact holes 62.

The switching drain electrode 177a extends to be electrically connected to the first storage capacitor plate 128 and the driving gate electrode 125b through the contact hole 63 formed in the interlayer insulating layer 160.

The second storage capacitor plate 178 protrudes from the driving voltage line 171 to overlap the first storage capacitor plate 128. Accordingly, the first storage capacitor plate 128 and the second storage capacitor plate 178 form a storage capacitor Cst with the interlayer insulating layer 160 as a dielectric material.

The switching semiconductor layer 135a, the switching gate electrode 125a, the switching source electrode 176a, and the switching drain electrode 177a form a switching transistor T1. The driving semiconductor layer 135b, the driving gate electrode 125b, the driving source electrode 176b, and the driving drain electrode 177b form a driving transistor T2.

A passivation layer 180 is formed on the switching source electrode 176a, the driving source electrode 176b, the switching drain electrode 177a, and the driving drain electrode 177b.

A pixel electrode 710 which serves as a first electrode is formed on the passivation layer 180, the pixel electrode 710 may be formed of a transparent conductive material such as indium tin oxide (ITO), indium zinc oxide (IZO), zinc oxide (ZnO), or indium oxide (In₂O₃), or a reflective metal such as lithium (Li), calcium (Ca), lithium fluoride/calcium(LiF/Ca), lithium fluoride/aluminum (LiF/Al), aluminum (Al), silver (Ag), magnesium(Mg), or gold (Au). The pixel electrode 710 is electrically connected to the driving drain electrode 177b of the driving transistor T2 through a contact hole 181 which is formed in the interlayer insulating layer 160 to serve as an anode of the OLED 70.

A pixel defining layer 350 is formed on an edge of the passivation layer 180 and the pixel electrode 710. The pixel defining layer 350 has an opening 351 which exposes the pixel electrode 710. The pixel defining layer 180 may be formed of a resin such as polyacrylates or polyimides or a silica based inorganic material.

An organic emission layer 720 is formed in the opening 351 of the pixel defining layer 350. The organic emission layer 720 is formed of multiple layers including one or more of a light-emitting layer, a hole-injection layer (HIL), a hole-transporting layer (HTL), an electron-transporting layer (ETL), and an electron-injection layer (EIL). If the organic emission layer 720 includes all of the layers, the organic emission layer 720 is formed on a pixel electrode 710 which has the hole-injection layer as an anode and then the hole-transporting layer, the emission layer, the electron-transporting layer, and the electron-injection layer may be sequentially laminated thereon.

The organic emission layer 720 may include a red organic emission layer which emits red light, a green organic emission layer which emits green light, or a blue organic emission layer which emits blue light. The red, green, and blue organic emission layers are respectively formed in red, green, and blue pixels to implement a color image.

Further, in the organic emission layer 720, the red, green, and blue organic emission layers can be laminated on each of the red, green, and blue pixels and red, green, and blue color filters respectively formed for every pixel to implement a color image. As another example, a white organic emission layer which emits white light is formed on each of the red, green, and blue pixels and the red, green, and blue color filters respectively formed for every pixel to implement a color image. When the color image is implemented using the white organic emission layer and the color filters, there is no need to use a deposition mask which deposits the red, green, and blue organic emission layers on individual pixels.

The white organic emission layer described in another example can be formed as one organic emission layer or can also include a configuration in which a plurality of organic emission layers are laminated to emit white light. For example, a configuration in which at least one yellow organic emission layer and at least one blue organic emission layer are combined to emit white light, a configuration in which at least one cyan organic emission layer and at least one red organic emission layer are combined to emit white light, or a configuration in which at least one magenta organic emission layer and at least one green organic emission layer are combined to emit white light can also be included.

A common electrode 730 which serves as a second electrode is formed on the pixel defining layer 350 and the organic emission layer 720. The common electrode 730 may be formed of a transparent conductive material such as indium tin oxide (ITO), indium zinc oxide (IZO), zinc oxide (ZnO) or indium oxide (In₂O₃) or a reflective metal such as lithium (Li), calcium (Ca), lithium fluoride/calcium (LiF/Ca), lithium fluoride/aluminum (LiF/Al), aluminum (Al), silver (Ag), magnesium (Mg), or gold (Au). The common electrode 730 serves as a cathode of the OLED 70. The pixel electrode 710, the organic emission layer 720, and the common electrode 730 form an OLED 70.

While the described technology has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A laser crystallization apparatus for an organic light-emitting diode (OLED) display, the apparatus comprising:
a first laser unit configured to crystalize an amorphous silicon layer formed on a substrate so as to form a polycrystalline silicon layer including a plurality of protrusions; and
a second laser unit configured to remove at least a part of the protrusions.

2. The laser crystallization apparatus of claim 1, comprising:
a stage configured to receive a target substrate having an amorphous silicon layer formed thereon.

3. The apparatus of claim 2, wherein the first laser unit includes i) a first laser generator configured to generate a first laser beam and ii) a first focuser configured to focus the first laser beam and wherein the second laser unit includes i) a second laser generator configured to generate a second laser beam and ii) a second focuser configured to focus the second laser beam.

4. The apparatus of claim 3, wherein the second focuser is further configured to focus the second laser beam into a line beam.

5. The apparatus of claim 3, wherein the second focuser is further configured to focus the second laser beam into a conical beam.

6. The apparatus of claim 3, wherein the second focuser is further configured to focus the second laser beam so as to have a depth of focus near an upper surface of the polycrystalline silicon layer.

7. The apparatus of claim 6, wherein the second focuser is further configured to focus the second laser beam so as to have a focal point which is closer to the upper surface of the polycrystalline silicon layer than the heights of the protrusions.

8. The apparatus of claim 7, wherein the second laser unit is further configured to remove at least a part of the protrusions between about several nanoseconds (ns) to about several seconds (s) after the first laser unit crystalizes the amorphous silicon layer.

9. The apparatus of claim 3, wherein each of the first and second laser beams has an optical axis which is substantially perpendicular to an upper surface of the polycrystalline silicon layer.

10. The apparatus of claim 3, wherein each of the first and second laser beams has and optical axis which is inclined with respect to an upper surface of the polycrystalline silicon layer.

11. An organic light-emitting diode (OLED) display, comprising:
a substrate; and
a plurality of pixels formed over the substrate, each pixel comprising i) an OLED and ii) a plurality of thin film transistors (TFTs) electrically connected to the OLED,
wherein each of the TFTs comprises a semiconductor layer formed at least in part of polycrystalline silicon and including a plurality of protrusions, and
wherein the height of each of the protrusions is between about 80% to about 120% of the thickness of the semiconductor layer.

12. The OLED display of claim 11, wherein the thickness of the semiconductor layer is about 50 nm.

13. The OLED display of claim 11, wherein the protrusions are formed at grain boundaries in the polycrystalline silicon layer.

14. The OLED display of claim 11, wherein each of the OLEDs includes:
a first electrode electrically connected to a drain electrode of one of the TFTs;
an organic emission layer formed over the first electrode; and
a second electrode formed over the organic emission layer.
